# EUROPÄISCHE PATENTSCHRIFT

(11) **EP 1 344 070 B1**
(45) Veröffentlichungstag und Bekanntmachung des Hinweises auf die Patenterteilung: **02.05.2007**
(21) Anmeldenummer: 01989370.0
(22) Anmeldetag: 05.12.2001
(51) Int. Cl.: G01R 19/00, G01R 31/28

(54) **VERFAHREN UND VORRICHTUNG ZUR FUNKTIONSÜBERWACHUNG EINER ENDSTUFE MIT PULSWEITENMODULATION**
METHOD AND DEVICE FOR MONITORING THE FUNCTION OF AN OUTPUT STAGE WITH PULSE WIDTH MODULATION
PROCEDE ET DISPOSITIF DE SURVEILLANCE DE FONCTION D'UN ETAGE DE SORTIE A MODULATION D'IMPULSIONS EN LARGEUR

(30) Priorität: 14.12.2000 DE 10062190
(43) Veröffentlichungstag der Anmeldung: 17.09.2003
(73) Patentinhaber: ROBERT BOSCH GMBH, 70442 Stuttgart (DE)
(72) Erfinder: FAHRBACH, Wilhelm, 74321 Bietigheim (DE); GLADOW, Juergen, 70469 Stuttgart (DE); GYOERFI, Karl-Heinz, 71263 Weil Der Stadt (DE); WEYHERSMUELLER, Udo, 71229 Leonberg (DE)
(74) Vertreter: Hörschler, Wolfram Johannes
(86) Internationale Anmeldenummer: PCT/DE2001/004568
(87) Internationale Veröffentlichungsnummer: WO 2002/048721

(56) Entgegenhaltungen:
- EP-A- 0 813 069
- DE-A- 3 921 329
- DE-A- 19 915 593
- DE-A- 19 928 135
- PATENT ABSTRACTS OF JAPAN vol. 014, no. 028 (E-875), 19. Januar 1990 (1990-01-19) & JP 01 264571 A (SUMITOMO HEAVY IND LTD), 20. Oktober 1989 (1989-10-20)

## Beschreibung

### Technisches Gebiet

Endstufen mit Pulsweitenmodulation finden einen breiten Einsatz bei der Ansteuerung von elektrischen Verbrauchern, beispielsweise von Stellgliedern (Aktoren) in Kraftfahrzeugmotoren oder Industrieanlagen. Sie liefern die von den Verbrauchern benötigte Leistung. Dabei können an den Endstufen Fehler auftreten, wie beispielsweise Lastabfall, Kurzschluß nach Masse oder Kurzschluß nach Pluspotential. Folglich gilt es, ein einfaches und sicheres Verfahren zur Erkennung der Fehler bereitzustellen.

### Stand der Technik

DE 40 12 109 A1 betrifft eine Vorrichtung zur Funktionsüberwachung eines elektrischen Verbrauchers, seiner Endstufe, seiner Ansteuerung und der dazugehörigen Verbindungen. Parallel zur Endstufe wird eine Fehlererfassungslogik geschaltet, die durch einen hardwaremäßigen Vergleich der Eingangs- und Ausgangspotentiale und mit Hilfe eines Bezugspotentials die möglichen Fehlerfälle "Kurzschluß nach Masse", "Kurzschluß nach Pluspotential" sowie "Lastabfall" unterscheidet.

DE 198 51 732 A1 bezieht sich auf ein Verfahren und eine Vorrichtung zur Überwachung wenigstens einer Stromregelstufe für einen elektrischen Verbraucher. Die Stromregelstufe umfaßt wenigstens ein Schaltmittel und einen Stromregler. Der Verbraucher wird von einem durch ein Tastverhältnis bestimmten Strom durchflossen, der von dem Stromregler auf einen Sollwert einregelbar ist. Zur Überwachung der Stromregelstufen wird das Tastverhältnis und/oder eine aus dem Tastverhältnis abgeleitet Größe mit einem Schwellwert verglichen und bei einer Abweichung auf Fehler erkannt. Der Schwellwert ergibt sich dabei aus der jeweils entsprechenden Größe, die sich an wenigstens einer der übrigen Stromregelstufen einstellt. Als Tastverhältnis wird das Verhältnis zwischen der Zeitdauer in der das Schaltmittel geschlossen ist und der gesamten Ansteuerdauer bezeichnet. Es kann aber beispielsweise auch das Verhältnis zwischen der Zeitdauer, in der das Schaltmittel geschlossen ist und der Zeitdauer, in der das Schaltmittel geöffnet ist, verwendet werden.

DE 199 28 135 A1 betrifft eine Schaltungsanordnung zur Ansteuerung eines Elektromotors sowie eine Auswerteeinrichtung zur Unterscheidung zwischen einem fehlerfreiem und einem fehlerhaften Betriebzustand. Des weiteren beschreibt D1 ein analoger Eingang einer Steuereinheit und die Filterung durch einen Tiefpass-Filter R2/C2.

DE 199 15 593 A1 betrifft eine Auswerteeinheit für eine Ansteuerschaltung. Eine gemittelte Stromstärke wird berechnet und zu einem analogen Eingang der Auswerteeinheit geführt.

Bisher werden im Stande der Technik hauptsächlich zwei Möglichkeiten zur Funktionsüberwachung von Endstufen mit Pulsweitenmodulation (PWM) genutzt. Eine Auswertung des Statusausgangs der intelligenten Endstufe oder die Ermittlung des Status durch Rückführung des Endstufenausgangs auf einem Digitalport. Beide Möglichkeiten sind nicht für den aktiven PWM-Betrieb geeignet. Bei der Auswertung des Statussignals der intelligenten Endstufe wird der aktuelle Status erst verzögert geliefert, wobei die Verzögerung endstufenspezifisch ist und beispielsweise mehr als 1 ms betragen kann. Bei der Rückführung auf einen Digitaleingang ist es notwendig, das Ausgangssignal exakt zu einem bestimmten Zeitpunkt abzutasten. Dies ist nur mit einer hohen Rechenleistung bis zu systemabhängigen Grenzen zu realisieren. Bei der Anwendung der beiden genannten Möglichkeiten zur Funktionsüberwachung von PWM-Endstufen ist ein Abtasten des Ausgangssignals zur richtigen Zeit nur bei Kenntnis der Laufzeiten vom Ansteuern einer Endstufe bis zu der Auswirkung des Steuersignals an dem Ausgang der Endstufe möglich.

### Darstellung der Erfindung

Vorteile sind vor allem darin zu erblikken, daß die Überwachung einer Endstufe weniger Rechenleistung erfordert, als beispielsweise die synchrone Abtastung bei der digitalen Rückführung des Endstufenausgangs. Ferner ist die Überwachung zu jedem Zeitpunkt möglich, also auch im aktiven Betrieb der Endstufe. Des weiteren sind die zur Überwachung benötigten elektrischen Bauelemente kostengünstige Standardbauteile, wie Widerstände und Kondensatoren. Ein weiterer Vorteil der vorliegenden Erfindung ist, daß sich die oben genannten Laufzeiten bei der Ansteuerung durch die Mittelung egalisieren.

Das erfindungsgemäße Verfahren und die erfindungsgemäße Vorrichtung zur Überwachung von Endstufen sind für Endstufen geeignet, die durch einen Mikrocontroller mit einem Signal mit beliebigem Tastverhältnis angesteuert werden, bevorzugt für Endstufen mit Pulsweitenmodulation (PWM). Die Diagnose mit Hilfe der vorliegenden Erfindung ist sowohl bei PWM-Highside-Endstufen als auch bei PWM-Lowside-Endstufen und unabhängig von der Frequenz, mit der sie angesteuert werden möglich. Die Ansteuerfrequenz wird lediglich durch die Schaltzeiten der Endstufen begrenzt.

Bei der vorliegenden Erfindung wird das Ausgangssignal der Endstufe über eine elektrische Schaltung gemittelt und mit einem aus dem Eingangssignal der Endstufe berechneten Sollwert verglichen. Vorteilhaft bei der Mittelung des Ausgangssignals ist, daß Laufzeiten von der Ansteuerung der Endstufe bis zu der Auswirkung des Ansteuersignals egalisiert werden und daß die Diagnose der Endstufe zu jedem Zeitpunkt möglich ist. Bei einer Abweichung des gemittelten Wertes vom berechneten Sollwert wird ein Fehler diagnostiziert. Im störungsfreien Betrieb sind die beiden Werte (im Rahmen eines Toleranzbereichs) gleich. Ein Vorteil des Verfahrens, bei dem sich die beiden zu vergleichenden Werte aus dem Eingangs- und dem Ausgangssignal einer Endstufe ergeben, ist, daß keine weitere Endstufe für Vergleichswerte herangezogen werden muß, die Diagnose also völlig unabhängig von anderen Endstufen erfolgt.

Die Mittelung des Ausgangssignals der zu überwachenden Endstufe erfolgt bei der vorliegenden Erfindung durch eine elektrische Schaltung, die mindestens einen Widerstand und mindestens einen Filter enthält, bevorzugt ein Widerstandsnetzwerk und einen Filter. Der Filter ist ein Tiefpaßfilter, der einen Kondensator enthält. Vorteil dieser passiven Bauelemente, (d.h. Widerstände und Kondensatoren) ist, daß sie kostengünstig sind, da es sich um Standardbauteile handelt. Vorzugsweise wird die Kapazität der Kondensatoren so gewählt, daß bei gegebener Schaltfrequenz der überwachten Endstufe eine Glättung des Ausgangssignals der Endstufe erzielt wird. Die Widerstände im Widerstandsnetzwerk werden erfindungsgemäß so dimensioniert, daß sich im Leerlauf der Endstufe an ihrem Ausgang ein Spannungswert von 1/4 der Batteriespannung bis 3/4 der Batteriespannung, bevorzugt 1/2 der Batteriespannung, einstellt und am Analogeingang des Mikrocontrollers der vollständige Arbeitsbereich der Endstufe abgebildet wird.

Erfindungsgemäß wird der über die elektrische Schaltung gemittelte Wert auf einen Analogeingang des Mikrocontrollers rückgeführt, wo sich je nach Tastverhältnis eine bestimmte Spannung einstellt. Vorteil der Rückführung auf einen Analogeingang gegenüber einem Digitaleingang ist, daß das Ausgangssignal nicht zu einem exakten Zeitpunkt abgetastet werden muß und somit Rechenleistung gespart wird. Zur Berechnung eines Sollwertes für den Vergleich mit dieser Spannung erfolgt eine Mittelung des Mikrocontroller-Ansteuersignals durch eine softwaretechnische Nachbildung der erfindungsgemäßen Rückführung. Dies bedeutet, daß eine Software die Endstufe und die elektrische Schaltung simuliert und das zu dem Endstufen-Eingangssignal mit einem beliebigen Tastverhältnis erwartete Schaltungsausgangssignal berechnet Bei Auftreten eines Fehlers wird anhand der Größe der Abweichung des durch die Schaltung gemittelten Wertes von dem berechneten Sollwert eine Aussage über die Art des Fehlers getroffen.

### Zeichnung

Anhand der Zeichnung wird die Erfindung nachstehend näher erläutert.

Es zeigt:

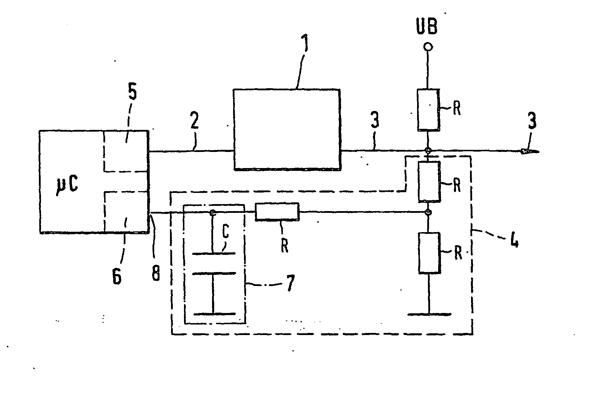

- Figur 1: Den Aufbau einer Vorrichtung zur Überwachung einer Endstufe.

### Ausführungsvarianten

Figur 1 zeigt eine mögliche Ausführungsform der erfindungsgemäßen Vorrichtung zur Überwachung einer PWM-Highside-Endstufe, die in dem erfindungsgemäßen Verfahren Anwendung finden kann.

Von dem Mikrocontroller µC wird die PWM-Highside-Endstufe 1 mit einem beliebigen Tastverhältnis angesteuert. Zur Diagnose der Endstufe 1 wird das Ausgangssignal 3 der Endstufe über ein Widerstandsnetzwerk R und einen Filter 7 auf einen Analogeingang 8 des Mikrocontrollers µC rückgeführt.

Die Widerstände R in der Schaltung 4 sind beispielsweise so dimensioniert, daß sich im Leerlauf am Ausgang 3 der Endstufe 1 eine Spannung einstellt, die 1/2 der Batteriespannung UB beträgt.

In der in Figur 1 dargestellten Ausführungsform der Erfindung wird als Filter 7 ein Tiefpaßfilter eingesetzt, der einen Kondensator C enthält Die Kapazität des Kondensators C wird so gewählt, daß bei der vorliegenden Schaltfrequenz der Endstufe 1 eine Glättung des Ausgangssignals 3 der Endstufe erfolgt.

Je nach Tastverhältnis stellt sich als Ausgangssignal 6 der Schaltung 4 am Analogeingang 8 des Mikrocontrollers µC eine Spannung ein. Diese Spannung 6 wird mit einem Sollwert 5 verglichen. Der Sollwert 5 wird durch einen softwaretechnische Nachbildung der Rückführung im Mikrocontroller µC berechnet. Dabei wird die Endstufe 1 und die Schaltung 4 zur Mittelung des Ausgangssignals 3 der Endstufe 1 simuliert und das zu dem Endstufen-Eingangssignal 2 erwartete Schaltungsausgangssignal 6 berechnet. Der berechnete Sollwert 5 wird mit dem durch die Schaltung 4 gemittelten Ausgangssignal 6 verglichen. Sind die beiden Werte (innerhalb eines Toleranzbereichs) gleich, so arbeitet die Endstufe 1 ordnungsgemäß. Bei Auftreten eines Fehlers weicht der gemittelte Wert 6 von dem Sollwert 5 ab. Anhand der Größe dieser Abweichung kann eine Aussage über die Art des Fehlers getroffen werden.

Liegt der gemessene Wert 6 unterhalb des berechneten 5, so wird ein Kurzschluß nach Masse diagnostiziert. Liegt der gemessene 6 über dem berechneten 5, so liegt entweder ein Lastabfall oder ein Kurzschluß nach Batteriespannung UB vor. Eine Unterscheidung dieser beiden Fehler kann nach Abschalten der Endstufe getroffen werden. Die dann rückgelesene Spannung entspricht (in diesem Ausführungsbeispiel) 1/2 der Batteriespannung UB bei Lastabfall. Liegt die rückgelesene Spannung weit darüber, so ist der aufgetretene Fehler ein Kurzschluß nach Batteriespannung UB. Die Dimensionierung der Widerstände derart, dass sich wie in diesem Beispiel im Leerlauf am Ausgang der Endstufe 1/2 der Batteriespannung UB einstellt ist besonders bevorzugt, da diese Leerlaufspannung besonders weit von den beiden Grenzwerten 0V an Masse und der Batteriespannung UB entfernt ist. Dadurch lassen sich die oben genannten Fehler am einfachsten feststellen, da die gemessenen Spannungen mit Toleranzen behaftet sind und sich diese Toleranzen wegen dieser möglichst großen Differenz zu den Grenzwerten nicht mit anderen Toleranzbändern überlappen. Der jeweilige Defekt kann somit sicher erkannt werden.

### Bezugszeichenliste

- 1: Endstufe
- 2: Eingangssignal der Endstufe mit beliebigem Tastverhältnis
- 3: Ausgangssignal der Endstufe
- 4: Schaltung zur Mittelung
- 5: Berechneter Sollwert
- 6: Gemittelter Wert = Ausgangssignal der Schaltung
- 7: Filter
- 8: Analogeingang des Mikrocontrollers
- C: Kondensator
- µC: Mikrocontroller
- R: Widerstand
- UB: Batteriespannung

## Patentansprüche

1. Verfahren zur Überwachung wenigstens einer Endstufe (1), die durch einen Mikrocontroller (µC) mit einem Eingangssignal mit beliebigem Tastverhältnis (2) angesteuert wird, wobei das Ausgangssignal (3) der Endstufe (1) über eine elektrische Schaltung (4) gemittelt und mit einem aus dem Eingangssignal (2) der Endstufe (1) berechneten Sollwert (5) verglichen wird, wobei eine Abweichung des gemittelten Wertes (6) von dem Sollwert (5) auf einen Fehler hindeutet, wobei das Ausgangssignal (3) der Endstufe durch mindestens einen RC-Tiefpass gefiltert und auf einen Analogeingang (8) des Mikrocontrollers (µC) rückgeführt wird, wobei eine Batteriespannung (UB) über einen Widerstand am Ausgangssignal (3) der Endstufe (1) angeschlossen wird, **dadurch gekennzeichnet, dass** das Ausgangssignal (3) der Endstufe über einen Spannungsteiler abgegriffen wird und dass weitere Widerstände (R) in der Schaltung (4) so dimensioniert sind, dass sich im Leerlauf am Ausgang (3) der Endstufe (1) ein Spannungswert entsprechend 1/4 der Batteriespannung (UB) bis 3/4 der Batteriespannung (UB) einstellt, dass anhand der Abweichung des durch die Schaltung (4) gemittelten Wertes (6) von dem Sollwert (5) eine Aussage über die Art des Fehlers getroffen wird .

2. Verfahren gemäß Anspruch 1, **dadurch gekennzeichnet, dass** der Sollwert (5) durch den Mikrocontroller (µC) berechnet wird.

3. Verfahren gemäß Anspruch 2, **dadurch gekennzeichnet, dass** der Mikrocontroller (µC) die Endstufe (1) und die elektrische Schaltung (4) simuliert und das zu einem Eingangssignal der Endstufe mit einem beliebigem Tastverhältnis (2) erwartete Ausgangssignal der Schaltung (6) berechnet.

4. Vorrichtung zur Überwachung wenigstens einer Endstufe (1), die durch einen Mikrocontroller (µC) mit einem Eingangssignal mit beliebigem Tastverhältnis (2) angesteuert ist, mit einer elektrischen Schaltung (4) zur Mittelung des Ausgangssignals (3) der Endstufe (1), mit einer Batteriespannung, die über einen Widerstand am Ausgangssignal (3) der Endstufe (1) angeschlossen sind, wobei der Mikrocontroller (µC) ausgestaltet ist, um aus dem Eingangssignal der Endstufe mit einem beliebigen Tastverhältnis (2) einen Sollwert (5) zu berechnen, wobei die Vorrichtung weiterhin Mittel zum Vergleichen des Sollwertes (5) mit dem Ausgangssignal der Schaltung (6) aufweist sowie Mittel zum Erkennen der Art eines Fehlers aus einer Abweichung des gemittelten Wertes (6) von dem Sollwert (5), wobei das Ausgangssignal (3) der Endstufe durch mindestens ein RC-Tiefpass gefiltert auf einen Analogeingang (8) des Mikrocontrollers (µC) rückgeführt ist, **dadurch gekennzeichnet, dass** das Ausgangssignal (3) der Endstufe über einen Spannungsteiler abgegriffen ist und dass die Widerstände (R) in der Schaltung (4) so dimensioniert sind, dass sich im Leerlauf am Ausgang (3) der Endstufe (1) ein Spannungswert entsprechend 1/4 der Batteriespannung (UB) bis 3/4 der Batteriespannung (UB) einstellt.

5. Vorrichtung gemäß Anspruch 5, **dadurch gekennzeichnet, dass** der mindestens ein RC-Tiefpass mindestens einen Kondensator (C) enthält, wobei die Kapazität des mindestens einen Kondensators (C) so gewählt ist, dass bei der Schaltfrequenz der überwachten Endstufe (1) eine Glättung des Ausgangssignals (3) der Endstufe erzielt wird.

6. Vorrichtung gemäß Anspruch 5, **dadurch gekennzeichnet, dass** sich im Leerlauf am Ausgang (3) der Endstufe (1) ein Spannungswert entsprechend 1/2 der Batteriespannung (UB) einstellt.

7. Vorrichtung gemäß Anspruch 5, **dadurch gekennzeichnet, dass** der Mikrocontroller (µC) ausgestaltet ist, um die Endstufe (1) und die elektrische Schaltung (4) zu simulieren und das zu einem Eingangssignal der Endstufe mit einem beliebigen Tastverhältnis (2) erwartete Ausgangssignal der Schaltung (6) zu berechnen.

8. Vorrichtung gemäß Anspruch 5, **dadurch gekennzeichnet, dass** die überwachten Endstufen (1) Highside- oder Lowside-Endstufen sind.

## Claims

1. Method for monitoring at least one output stage (1) which is driven by a microcontroller (µC) using an input signal having any desired duty ratio (2), the output signal (3) from the output stage (1) being averaged using an electrical circuit (4) and being compared with a desired value (5) that is calculated from the input signal (2) for the output stage (1), a discrepancy between the averaged value (6) and the desired value (5) indicating an error, the output signal (3) from the output stage being filtered by at least one RC low-pass filter and being fed back to an analogue input (8) of the microcontroller (µC), and a battery voltage (UB) being connected to the output signal (3) from the output stage (1) via a resistor, **characterized in that** the output signal (3) from the output stage is tapped off using a voltage divider, and **in that** further resistors (R) in the circuit (4) are dimensioned in such a manner that, during no-load operation, a voltage value corresponding to 1/4 of the battery voltage (UB) to 3/4 of the battery voltage (UB) is set at the output (3) of the output stage (1), and **in that** the discrepancy between the value (6) that is averaged by the circuit (4) and the desired value (5) is used to make a statement regarding the type of error.

2. Method according to Claim 1, **characterized in that** the desired value (5) is calculated by the microcontroller (µC).

3. Method according to Claim 2, **characterized in that** the microcontroller (µC) simulates the output stage (1) and the electrical circuit (4) and calculates the output signal from the circuit (6), which output signal is expected for an input signal for the output stage having any desired duty ratio (2).

4. Device for monitoring at least one output stage (1) which is driven by a microcontroller (µC) using an input signal having any desired duty ratio (2), said device having an electrical circuit (4) for averaging the output signal (3) from the output stage (1), and having a battery voltage which is connected to the output signal (3) from the output stage (1) via a resistor, the microcontroller (µC) being configured to calculate a desired value (5) from the input signal for the output stage having any desired duty ratio (2), the device also having means for comparing the desired value (5) with the output signal from the circuit (6) and means for identifying the type of error from a discrepancy between the averaged value (6) and the desired value (5), the output signal (3) from the output stage being fed back to an analogue input (8) of the microcontroller (µC) after having been filtered by at least one RC low-pass filter, **characterized in that** the output signal (3) from the output stage is tapped off using a voltage divider, and **in that** the resistors (R) in the circuit (4) are dimensioned in such a manner that, during no-load operation, a voltage value corresponding to 1/4 of the battery voltage (UB) to 3/4 of the battery voltage (UB) is set at the output (3) of the output stage (1).

5. Device according to Claim 4, **characterized in that** the at least one RC low-pass filter contains at least one capacitor (C), the capacitance of the at least one capacitor (C) being selected in such a manner that the output signal (3) from the output stage is smoothed at the switching frequency of the output stage (1) being monitored.

6. Device according to Claim 4, **characterized in that**, during no-load operation, a voltage value corresponding to 1/2 of the battery voltage (UB) is set at the output (3) of the output stage (1).

7. Device according to Claim 4, **characterized in that** the microcontroller (µC) is configured to simulate the output stage (1) and the electrical circuit (4) and to calculate the output signal from the circuit (6), which output signal is expected for an input signal for the output stage having any desired duty ratio (2).

8. Device according to Claim 4, **characterized in that** the output stages (1) being monitored are highside or low-side output stages.

## Revendications

1. Procédé de surveillance d'au moins un étage de puissance (1) commandé par un micro-contrôleur (µC) par un signal d'entrée ayant un rapport de travail (2) quelconque, le signal de sortie (3) de l'étage de puissance (1) étant moyenné par un circuit électrique (4) et comparé à une valeur de consigne (5) calculée à partir du signal d'entrée (2) de l'étage de puissance (1),
une déviation entre la valeur moyenne (6) et la valeur de consigne (5) suggérant un défaut,
le signal de sortie (3) de l'étage de puissance étant filtré par au moins un filtre passe-bas RC et conduit en retour à une entrée analogique (8) du micro-contrôleur (µC),
une tension de batterie (UB) étant reliée par l'intermédiaire d'une résistance au signal de sortie (3) de l'étage de puissance (1),
**caractérisé en ce que**
le signal de sortie (3) de l'étage de puissance est pris sur un diviseur de tension et
d'autres résistances (R) du circuit (4) sont dimensionnées pour qu'au ralenti, à la sortie (3) de l'étage de puissance (2) on a une valeur de tension correspondant à 1/4 de la tension de batterie (UB) jusqu'à 3/4 de la tension de batterie (UB),
et à l'aide de la déviation de la valeur moyenne (6) fournie par le circuit (4) par rapport à la valeur de consigne (5) on émet une information concernant la nature de défaut.

2. Procédé selon la revendication 1,
**caractérisé en ce qu'**
on calcule la valeur de consigne (5) par le micro-contrôleur (µC).

3. Procédé selon la revendication 2,
**caractérisé en ce que**
le micro-contrôleur (µC) simule l'étage de puissance (1) et le circuit électrique (4) et calcule le signal de sortie prévisible du circuit (6) pour un signal d'entrée de l'étage de puissance avec un rapport de travail (2) quelconque.

4. Dispositif de surveillance d'au moins un étage de puissance (1) commandé par un signal d'entrée à rapport de travail (2) quelconque fourni par un micro-contrôleur (µC), à un circuit électrique (4) pour former la moyenne du signal de sortie (3) de l'étage de puissance (1), et une tension de batterie en étant relié par une résistance au signal de sortie (3) de l'étage de puissance (1),
le micro-contrôleur (µC) étant équipé pour calculer une valeur de consigne (5) à rapport de travail (2) quelconque à partir du signal d'entrée de l'étage de puissance,
le dispositif comportant en outre des moyens pour comparer la valeur de consigne (5) au signal de sortie du circuit (6) et des moyens pour reconnaître la nature d'un défaut à partir de la déviation de la valeur moyenne (6) par rapport à la valeur de consigne (5), le signal de sortie (3) de l'étage de puissance filtré par au moins un filtre passe-bas RC, étant appliqué en retour à une entrée analogique (8) du micro-contrôleur (µC),
**caractérisé en ce que**
le signal de sortie (3) de l'étage de puissance est prélevé sur un diviseur de tension et
les résistances (R) du circuit (4) sont dimensionnées pour qu'en marche à vide la sortie (3) de l'étage de puissance (1) fournisse une tension comprise entre 1/4 de la tension de batterie (UB) jusqu'à 3/4 de la tension de batterie (UB).

5. Dispositif selon la revendication 4,
**caractérisé en ce qu'**
au moins un filtre passe-bas RC comporte au moins un condensateur (C) dont la capacité est choisie pour que la fréquence de commutation de l'étage de puissance (1), surveillé, le signal de sortie (3) de l'étage de puissance soit lissé.

6. Dispositif selon la revendication 5,
**caractérisé en ce qu'**
en marche à vide, la sortie (3) de l'étage de puissance (1) se règle sur une tension correspondant à 1/2 de la tension de batterie (UB).

7. Dispositif selon la revendication 5,
**caractérisé en ce que**
le micro-contrôleur (µC) est réalisé pour simuler l'étage de puissance (1) et le circuit électrique (4) et calculer le signal de sortie prévisible du circuit (6), comme signal d'entrée de l'étage de puissance avec un rapport de travail (2) quelconque.

8. Dispositif selon la revendication 5,
**caractérisé en ce que**
les étages de puissance (1) sont les étages de puissance côté haut ou côté bas.
